(19) **Europäisches Patentamt**
**European Patent Office**
**Office européen des brevets**

(11) **EP 3 394 886 B1**

(12) **EUROPÄISCHE PATENTSCHRIFT**

(45) Veröffentlichungstag und Bekanntmachung des Hinweises auf die Patenterteilung:
**18.12.2019 Patentblatt 2019/51**

(21) Anmeldenummer: **17701281.2**

(22) Anmeldetag: **13.01.2017**

(51) Int Cl.:
*H01L 23/36* (2006.01)   *H01L 23/473* (2006.01)
*H01L 25/07* (2006.01)   *H02M 7/00* (2006.01)
*H02M 5/44* (2006.01)

(86) Internationale Anmeldenummer:
**PCT/EP2017/050680**

(87) Internationale Veröffentlichungsnummer:
**WO 2017/133881 (10.08.2017 Gazette 2017/32)**

(54) **REIHENSCHALTUNGSANORDNUNG VON LEISTUNGSHALBLEITERN**

SERIES CIRCUIT ARRANGEMENT OF POWER SEMICONDUCTORS

CIRCUIT EN SÉRIE DE SEMI-CONDUCTEURS DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.02.2016 DE 102016201679**
**23.02.2016 DE 102016202748**

(43) Veröffentlichungstag der Anmeldung:
**31.10.2018 Patentblatt 2018/44**

(73) Patentinhaber: **Siemens Aktiengesellschaft**
**80333 München (DE)**

(72) Erfinder:
• **BENKERT, Katrin**
  **90571 Schwaig (DE)**
• **HOLWEG, Johann**
  **90513 Zirndorf (DE)**
• **LANDES, Harald**
  **90607 Rückersdorf (DE)**
• **LEONIDE, André**
  **90762 Fürth (DE)**

(56) Entgegenhaltungen:
CN-A- 1 617 660   DE-A1-102014 204 241
JP-A- S57 102 061   JP-A- S57 193 974
US-A- 4 051 509

**Beschreibung**

In Reihenschaltungsanordnungen von Leistungshalbleitern, beispielsweise in sogenannten Hochspannungsgleichspannungsübertragungskonvertern (HGÜ) wird ein Kühlkreislauf eingesetzt, dessen lokale Potentialverteilung durch Steuerelektroden an die Spannung der elektrischen Komponenten in unmittelbarer Umgebung angepasst wird. Dies geschieht, um Teilentladungen zwischen den kühlwasserführenden Rohrleitungen aus Kunststoff und den elektrischen Komponenten zu verhindern. Ferner werden nach dieser Art und Weise Korrosionsströme niedrig gehalten, die durch Potentialdifferenzen zwischen dem Kühlwasser und den metallischen, mit dem Kühlwasser in Kontakt tretenden Anlagenkomponenten hervorgerufen werden. Da die Steuerelektroden sich im Laufe der Zeit mit mechanisch harten Belägen überziehen, die abplatzen und Kühlleitungen verstopfen können, müssen die Steuerelektroden bei der periodischen Anlagenabschaltung gereinigt bzw. ausgetauscht werden.

Die Dokumente DE102014204241, US4051509, CN1617660 und JPS57193974 offenbaren jeweils bekannte Reihenschaltungsanordnungen von Leistungshalbleitern.

Herkömmliche Reihenschaltungsanordnungen weisen Kühlwasserverteilerleitungen auf, wobei ausgehend von einem Kühlwasserzulauf bzw. Kühlwasserablauf beidseitig Teilmodule von Reihenschaltungen angeordnet sind und ein Bereich um den Kühlwasserzulauf herum aus konstruktiven Gründen in der Regel nicht mit entsprechenden Leistungshalbleiterbauelementen und Kühldosen bestückt ist. Zur Steuerung des Potentials in jedem dieser Teilmodule sind üblicherweise in jedem Teilmodul, beidseitig vom Kühlwasserzulauf bzw. Kühlwasserabfluss, jeweils zwei Steuerelektroden vorgesehen, die mit den beidseitig ersten Kühldosen verbunden sind, so dass das Potential im Zwischenraum, also im Bereich des Zulaufes auf dem Mittelwert aus den Potentialen an den Verteilerenden gehalten wird. Somit sind in einer herkömmlichen Reihenschaltungsanordnung pro Kühlwasserverteilerleitung jeweils vier Steuerelektroden, bezogen auf jeweils zwei Kühlwasserverteilerleitungen also insgesamt acht Steuerelektroden vorgesehen.

Die Aufgabe der Erfindung besteht darin, die Anzahl von Steuerelektroden in einer Reihenschaltungsanordnung von Leistungshalbleitern zu reduzieren und somit Kosten für den Wartungsaufwand einzusparen.

Die Lösung der Aufgabe besteht in einer Reihenschaltungsanordnung von Leistungshalbleitern mit den Merkmalen des Patentanspruches 1.

Die Reihenschaltungsanordnung von Leistungshalbleitern nach Patentanspruch 1 weist eine Kühlwasservorrichtung auf, die wiederum Kühldosen umfasst, an denen Leistungshalbleiter angeordnet sind. Diese Kühldosen stehen mit den Leistungshalbleitern elektrisch leitend in Verbindung und sie dienen zur Kühlung dieser Leistungshalbleiter, in dem durch die Kühldosen ein Kühlmedium, insbesondere Kühlwasser, durchgeleitet wird. Ferner umfasst die Kühlwasserverteilungsvorrichtung mindestens zwei Kühlwasserverteilerleitungen, wobei eine erste Kühlwasserverteilerleitung einen Kühlwasserzulauf und eine zweite Kühlwasserverteilerleitung einen Kühlwasserabfluss aufweist. Die Kühldosen sind zwischen den Kühlwasserverteilerleitungen bezüglich eines Kühlwasserstromes parallel geschaltet und es ist für jede Kühldose an jeder der beiden Kühlwasserverteilerleitungen eine Abzweigung vorgesehen, über die eine Verbindungsleitung zur Kühldose führt. Ferner ist in den Kühlwasserverteilerleitungen endseitig jeweils eine Steuerelektrode angeordnet. Da jede Kühlwasserverteilerleitung zwei Enden hat, sind für jede dieser Verteilerleitungen zwei Steuerelektroden vorgesehen. Die Erfindung zeichnet sich dadurch aus, dass für wenigstens einen Teil der Kühldosen die Abzweigungen an den Kühlwasserverteilerleitungen relativ zur Lage der jeweiligen Kühldose versetzt zu einer geometrisch kürzest möglichen Anbindung an die Kühlwasserverteilerleitungen angeordnet sind, so dass eine Potentialdifferenz zwischen den Kühldosen und den Abzweigungen minimiert ist.

Gegenüber dem Stand der Technik weist die beschriebene, erfindungsgemäße Reihenschaltungsanordnung pro Kühlwasserverteilerleitung nur zwei Steuerelektroden auf. Pro Reihenschaltungsanordnung wird gegenüber dem Stand der Technik die Anzahl der Steuerelektroden halbiert, weshalb auch der Aufwand und die Kosten für die Wartung und die Aufrechterhaltung der Steuerelektroden erheblich reduziert werden.

In einer Ausgestaltungsform der Erfindung ist der Kühlwasserzulauf und der Kühlwasserabfluss bezüglich der Steuerelektroden mittig an der Kühlwasserverteilerleitung angeordnet. Die Abzweigung der Kühldosen an den Kühlwasserverteilerleitungen sind in dieser Ausgestaltungsform bezüglich der jeweiligen Kühldose in Richtung des Kühlwasserzulaufes oder des Kühlwasserablaufes versetzt angeordnet. Dabei kann es zudem zweckmäßig sein, dass eine erste Abzweigung einer ersten Kühldose direkt im Bereich des Kühlwasserzulaufes angebracht ist, da sich an dieser Stelle das Potential der beiden mittleren Kühldosen einstellt. Besonders vorteilhaft ist, wenn die Kühlwasserverteilerleitungen durch die beschriebene Anordnung der versetzt angebrachten Abzweigungen von Verbindungsleitungen zu den Kühldosen frei von weiteren Steuerelektroden sind, ausser den am Ende der Verteilerleitungen angebrachten .

Der geeignete Abstand zwischen dem Kühlwasserzulauf und der Abzweigung zu einer jeweiligen Kühldose kann durch folgende Beziehung ermittelt werden:

$$n(L_0/n_{max} + L1)$$

Hierbei ist der Abstand $L_0$ der Abstand zwischen dem Kühlwasserzulauf und einer ersten Kühldose, der Abstand L1 bezeichnet den konstanten Abstand aller weiteren Kühldosen zueinander und die Ziffer n ist die fortlaufende Anzahl der Kühldosen, wobei die erste Kühldose mit 0 beginnt und $n_{max}$ die Gesamtzahl der Halbleiter zwischen dem Kühlwasserzufluss und der endseitig angeordneten Steuerelektrode darstellt. Durch diese Formel wird ein diskreter Wert bestimmt, der auf einer Ableitung von den Werten $L_0$ und L1 nach dem Stand der Technik und der Anzahl der Kühldosen beruht. Dieser ist dazu geeignet, dem tatsächlichen, optimalen Abzweigungspunkt nahezukommen. Grundsätzlich wird die gleiche Wirkung erreicht, wenn der Abstand zwischen der endseitigen Steuerelektrode zu dem Kühlwasserzufluss (entspricht im Stand der Technik dem Abstand $n_{max} * L_1 + L_0$) in $n_{max}$ - Abschnitte mit gleicher Länge unterteilt wird. Grundsätzlich ist es zweckmäßig, anschließend das optimale Potential in der Nähe dieses Punktes durch Messung zu ermitteln. Grundsätzlich basiert der angegebene Wert auf Messwerten und ist entsprechend mit einer Abweichung von +/- 5 % behaftet, so dass die entsprechende Abzweigung in dem genannten Intervall um den ermittelten Wert liegt.

Weitere Ausgestaltungsformen und weitere Merkmale der Erfindung werden anhand der folgenden Figuren näher beschrieben. Dabei handelt es sich lediglich um exemplarische Ausgestaltungsformen, die keine Einschränkung des Schutzbereiches darstellen. Für Merkmale mit derselben Bezeichnung, jedoch in anderer Ausgestaltungsform werden dabei dieselben Bezugszeichen verwendet.

Dabei zeigen:

Figur 1     eine Reihenschaltungsanordnung nach dem Stand der Technik,

Figur 2     eine Reihenschaltungsanordnung von Leistungshalbleitern mit einer Kühlwasservorrichtung mit einer gegenüber dem Stand der Technik geänderten Abzweigungen/Verbindungen zwischen der Kühlwasserleitung und den Kühldosen und

Figur 3     eine graphische Darstellung des Potentialverlaufs in der Kühlwasserverteilungsvorrichtung.

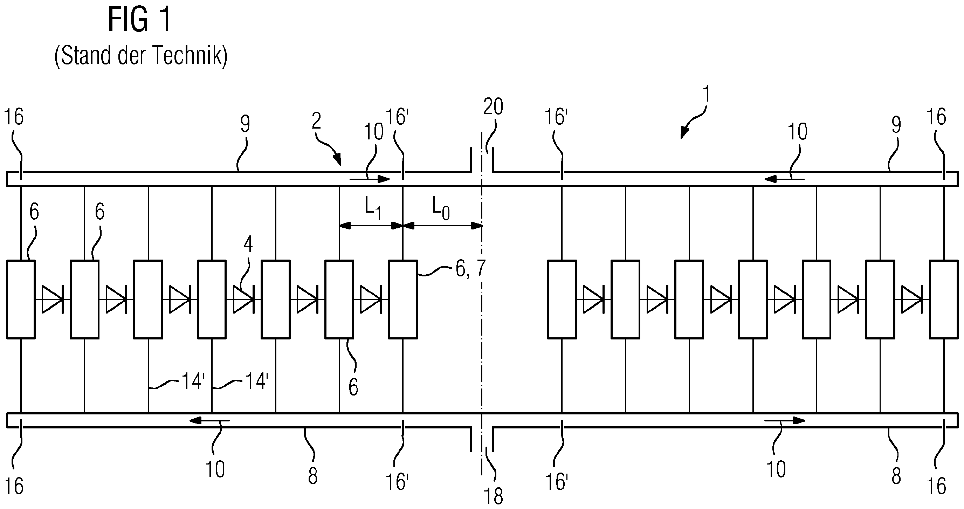

In Figur 1 ist eine Darstellung einer herkömmlichen Reihenschaltungsanordnung von Leistungshalbleitern gegeben. Hierbei handelt es sich um eine Thyristorschaltung für eine Hochspannungsgleichspannungsübertragungsanlage (HGÜ-Anlage). Dabei sind Kühlwasserverteilerleitungen 8 und 9 vorgesehen, wobei die Verteilerleitung 8 einen Kühlwasserzulauf 18 aufweist und die Verteilerleitung 9 einen Kühlwasserabfluss 20 aufweist. Bezüglich eines Kühlwasserstroms 10 sind Kühldosen 6 in der Kühlwasserverteilungsvorrichtung 2 parallel geschaltet. Die Kühldosen 6 wiederum sind elektrisch leitend mit Leistungshalbleitern 4 in Reihe geschaltet. An den jeweiligen Enden der Kühlwasserverteilerleitungen 8 und 9 sind Steuerelektroden 16 vorgesehen. Die Steuerelektroden 16 dienen dazu, Teilentladungen zwischen den entsprechenden Rohrleitungen, insbesondere den Kühlwasserverteilerleitungen 8 und 9 sowie den Verbindungsleitungen 14' und den Kühldosen 6 zu verhindern. Ferner dienen die Steuerelektroden dazu, Korrosionsschäden so niedrig wie nötig zu halten, die durch Potentialdifferenzen zwischen dem Kühlwasser und den metallischen Anlagekomponenten, wie z.B. dem Aluminium von den Kühldosen 6, auftreten können.

**Ferner sind im Stand der Technik neben den endseitigen Steuerelektroden 16 Mittensteuerelektroden 16' vorgesehen, die bevorzugt an der Abzweigung von der Kühlwasserverteilerleitung 8, 9 zur jeweilig ersten Kühldose 7 angeordnet sind. Die Einstellung des Potentials im Kühlwasserkreislauf erfolgt dann so, dass das maximale bzw. minimale Potential bei den endseitigen Steuerelektroden 16 vorliegt und der Mittelwert aus diesen Potentialen an den Mittensteuerelektroden 16' vorliegt. Der gesamte Bereich zwischen den Mittenelektroden 16' liegt somit ebenfalls auf diesem Potentialmittelwert. Diese beschriebene Ausgestaltungsform zeigt den Stand der Technik.**

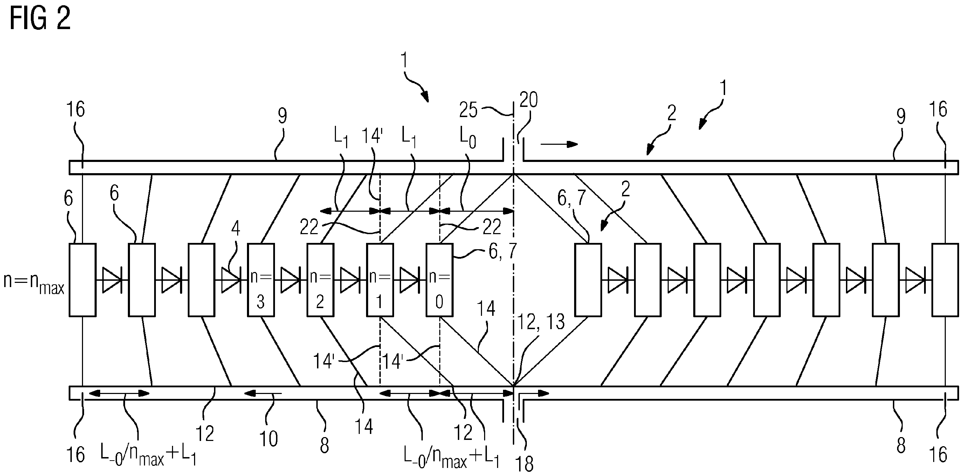

Die in Figur 2 beschriebene Reihenschaltungsanordnung mit einer Kühlvorrichtung ist in weiten Teilen analog zu der Anordnung gemäß Figur 1 und dem Stand der Technik ausgestaltet, sie weist aber zwei wesentliche Unterschiede auf. Zum einen wird auf die Mittensteuerelektroden 16' verzichtet, weshalb die hier beschriebene Anordnung lediglich die endseitigen Steuerelektroden 16 aufweist. Ferner sind die Abzweigungen 12 und die dazugehörigen Verbindungsleitungen 14 zu den Kühldosen 6 relativ zur Lage der jeweiligen Kühldose 6 teilweise versetzt angeordnet. Die Versetzung ist bezüglich einer geometrisch kürzest möglichen Anbindung 14' zu sehen, die exemplarisch und nicht vollständig in der Darstellung gestrichelt zu den zugehörigen Kühldosen 6 eingezeichnet sind.

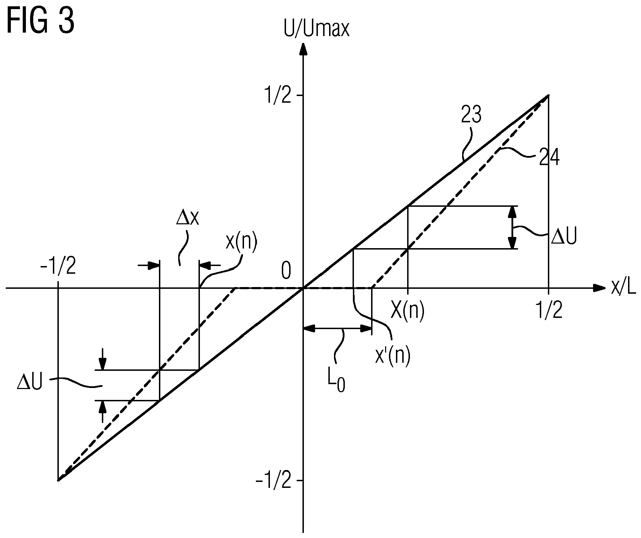

Diese Maßnahme, also das Versetzen der Abzweigungen 12 an der Kühlwasserverteilerleitung 8 bzw. 9 bewirkt, dass die Potentialdifferenz im Verbindungsschlauch zwischen der jeweiligen Kühldose 6 bzw. 7 und dem Abzweigpunkt an der Kühlwasserverteilerleitung minimiert wird bzw.verschwindet. Dafür ist es zweckmäßig, eine Abzweigung 13 für eine erste Kühldose 7 direkt an dem Bereich des Kühlwasserzuflusses anzubringen, an dem der Potentialmittelwert herrscht, wie noch im Weiteren bei der Erläuterung der Figur 3 gezeigt wird. Die Abstände zwischen den weiteren Abzweigungen 12 erfolgen nun äquidistant bis zur endseitigen Steuerelektrode 16 und der dort ebenfalls angebrachten Abzweigung zur letzten Kühldose $n_{max}$. Dieser äquidistante Abstand zwischen den Abzweigungen 12 lässt sich mit der Beziehung $L_0/n_{max}+L1$ ermitteln. Hierbei ist die Länge $L_0$

der Abstand zwischen der ersten Kühldose 7 und einer gedachten Mittelsenkrechten der Kühlwasserverteilerleitungen 8 und 9, die mit dem Bezugszeichen 25 versehen ist. Der Abstand $L_1$ ist der äquidistante Abstand zwischen den einzelnen Kühldosen 6. Um den Abzweigungspunkt 12 ausgehend von der Mittelsenkrechten 20 auf der Kühlwasserverteilerleitung 8 bzw. 9 zu ermitteln, muss der genannte Ausdruck noch mit der laufenden Nummer n der Kühldosen multipliziert werden, wobei die erste Kühldose 7 den Wert n=0 erhält, die darauffolgende Dose den Wert n=1 erhält.

In Figur 3 ist exemplarisch ein Verlauf von Spannungskurven 23 und 24 angegeben, wobei die X-Achse die Koordinate längs der Kühlwasserverteilerleitung 8 und 9 darstellt, gemessen in einer Einheit, die der Länge dieser Leitung gleich ist. Und der Nullpunkt der X-Achse mit der Mittelsenkrechten 25 in Figur 2 zusammenfällt. Auf der Y-Achse ist die Spannung in Einheiten von Umax, der Gesamtspannung der Thyristorkette, aufgetragen.

Die Gerade 23, die durch den Nullpunkt des Koordinatensystems verläuft, zeigt die Potentialkurve im Kühlwasserverteiler zwischen den beiden Steuerelektroden 16, die jeweils endseitig an jeder der Kühlwasserverteilerleitungen 8 oder 9 angeordnet sind. Die Kurve 24, die gestrichelt dargestellt ist, zeigt den Potentialverlauf, in der Reihenschaltung der Halbleiterbauelemente 4 , wobei der Maximal- bzw. der Minimalwert jeweils die Spannung an der jeweils äußersten Kühldose $n_{max}$ angibt. Strenggenommen verläuft diese Kurve eigentlich treppenförmig, da das Potential über die Dicke einer Kühldose hinweg konstant ist und nur in der Sperrschicht des Halbleiterbauelementes auf den Wert der benachbarten Kühldose springt. Der Ort, bei dem die Kurve 23 den y-Wert Null erreicht, spiegelt den Ort X'(0) der ersten Kühldose 7 wider, die auf dem Spannungsmittelwert der Thyristorkette liegt. Aus der Graphik ist an Hand der Kurve 23 zu erkennen, dass bei einem gleichen Abstand von der Mittelsenkrechten 25 in den Kühlwasserverteilerleitungen 8 und 9 ein anderes Potential vorliegt, als an der dazugehörigen Kühldose n bzw. an den dazugehörigen Hälften der benachbarten Halbleiterbauelemente. Dieser Unterschied ist graphisch durch die Linie ΔU dargestellt. Möchte man erreichen, dass die Spannungsdifferenz am Verbindungsschlauch zwischen Kühlwasserverteilerabzweig und Kühldose verschwindet, muss man den Schlauchabzweig auf die x-Koordinate jenes Punktes auf der Kurve 23 legen der das Potential der Kühldose n besitzt. Auf diese Weise erhält man den Punkt X'(n), an dem die Abzweigung 12 an der Verteilerleitung 8, 9 angeordnet sein muss, damit dieser Punkt dasselbe Potential aufweist, wie die dazugehörige Kühldose 6 am Ort X(n). Der Abstand ΔX, der auf der linken Seite im negativen X-Bereich der Graphik dargestellt ist, ist dann der Abstand, um den die Abzweigung 12 in Richtung des Kühlwasserverteilermittelpunktes, also in Richtung der gestrichelten Linie 25, verschoben werden muss und zwar gemessen von dem Ort des Kühlwasserverteilers 8 bzw. 9, der von der entsprechenden Kühldose 6 den geringsten Abstand hat.

**Patentansprüche**

1. Reihenschaltungsanordnung von Leistungshalbleitern (4) mit einer Kühlwasserverteilungsvorrichtung (2), umfassend an den Leistungshalbleitern (4) angeordnete Kühlwasserdosen (6), die mit den Leistungshalbleitern (4) elektrisch leitend in Verbindung stehen, sowie mindestens zwei Kühlwasserverteilerleitungen (8, 9), wobei eine erste Kühlwasserverteilerleitung (8) einen Kühlwasserzulauf (18) und eine zweite Kühlwasserverteilerleitung einen Kühlwasserabfluss (20) aufweist und wobei die Kühldosen (6) zwischen den Kühlwasserverteilerleitungen (8, 9) bezüglich eines Kühlwasserstroms (10) parallel geschaltet sind und für die Kühldosen (6) jeweils eine Abzweigung (12) an den Kühlwasserverteilerleitungen (8, 9) vorgesehen sind und die Kühldosen (6) über jeweils eine Verbindungsleitung (14) mit den Abzweigungen (12) verbunden sind, wobei ferner an den Kühlwasserverteilerleitungen (8, 9) endseitig jeweils eine Steuerelektrode (16) angeordnet ist, **dadurch gekennzeichnet, dass** für wenigstens einen Teil der Kühldosen (6) die Abzweigungen an den Kühlwasserverteilerleitungen (8, 9) relativ zur Lage der jeweiligen Kühldose (6) versetzt zu einer geometrisch kürzest möglichen Anbindung (22) an die Kühlwasserverteilungsleitungen (8, 9) angeordnet sind, so dass eine Potentialdifferenz (AU) zwischen den Kühldosen und den Abzweigungen minimiert ist.

2. Reihenschaltungsanordnung nach Anspruch 1, **dadurch gekennzeichnet, dass** der Kühlwasserzulauf (18) und der Kühlwasserabfluss (20) bezüglich der Steuerelektroden (16) mittig an den Kühlwasserverteilungsleitungen (8, 9) angeordnet sind und Abzweigungen (12) der Kühldosen (6) an der Kühlwasserverteilerleitung (8, 9) bezüglich der Kühldosen (6) in Richtung des Kühlwasserzulaufs (18) oder des Kühlwasserabflusses (20) versetzt angeordnet sind.

3. Reihenschaltungsanordnung nach Anspruch 1 oder 2, **dadurch gekennzeichnet, dass** eine erste Abzweigung (13) für eine erste Kühldose (7) im Bereich des Kühlwasserzulaufs (18) angebracht ist.

4. Reihenschaltungsanordnung nach einem der Ansprüche 1 bis 3, **dadurch gekennzeichnet, dass** die Kühlwasserverteilerleitungen (8, 9) frei von weiteren Steuerelektroden sind.

5. Kühlwasserverteilvorrichtung nach einem der vorhergehenden Ansprüche, **dadurch gekennzeichnet, dass** ein Abstand $L_0$ den Abstand zwischen dem Kühlwasserzulauf (18) und der ersten Kühldose (7) bezeichnet und ein Abstand $L_1$ den konstanten Abstand aller weiterer Kühldosen (6) zueinander bezeichnet, wobei die Ziffer n die fortlaufende Anzahl der Kühldosen (6, 7) bezeichnet, die mit 0 beginnt und $n_{max}$ die Gesamtanzahl der Leistungshalbleitern (4) zwischen dem Kühlwasserzufluss (18) und einer Steuerelektrode (16) ist, wobei sich der Abstand der Abzweigung (12) der n-ten Kühldose (6) von Kühlwasserzufluss durch die Beziehung $n(L_0/n_{max}+L1)$ ergibt.

## Claims

1. Series circuit arrangement of power semiconductors (4) with a cooling-water distribution apparatus (2), including cooling-water boxes (6) arranged on the power semiconductors (4), which are connected to the power semiconductors (4) in electrically conducting manner, and also at least two cooling-water distributor lines (8, 9), wherein a first cooling-water distributor line (8) exhibits a cooling-water inlet (18), and a second cooling-water distributor line exhibits a cooling-water outflow (20), and wherein the cooling chambers (6) are connected in parallel between the cooling-water distributor lines (8, 9) with respect to a cooling-water stream (10), and in each instance a branching (12) on the cooling-water distributor lines (8, 9) is provided for the cooling chambers (6) and the cooling chambers (6) are connected to the branchings (12) via a respective connecting line (14), wherein furthermore a control electrode (16) is arranged on the cooling-water distributor lines (8, 9), terminally in each instance, **characterized in that** for at least some of the cooling chambers (6) the branchings on the cooling-water distributor lines (8, 9) are arranged relative to the position of the respective cooling chamber (6) in offset manner in relation to a geometrically shortest possible link (22) to the cooling-water distributor lines (8, 9), so that a difference of potential (AU) between the cooling chambers and the branchings is minimized.

2. Series circuit arrangement according to Claim 1, **characterized in that** the cooling-water inlet (18) and the cooling-water outflow (20) are arranged centrically on the cooling-water distributor lines (8, 9) with respect to the control electrodes (16), and branchings (12) of the cooling chambers (6) on the cooling-water distributor line (8, 9) are arranged in offset manner with respect to the cooling chambers (6) in the direction of the cooling-water inlet (18) or the cooling-water outflow (20).

3. Series circuit arrangement according to Claim 1 or 2, **characterized in that** a first branching (13) for a first cooling chamber (7) is positioned in the region of the cooling-water inlet (18).

4. Series circuit arrangement according to one of Claims 1 to 3, **characterized in that** the cooling-water distributor lines (8, 9) are free from further control electrodes.

5. Cooling-water distribution apparatus according to one of the preceding claims, **characterized in that** a spacing $L_0$ denotes the spacing between the cooling-water inlet (18) and the first cooling chamber (7), and a spacing $L_1$ denotes the constant spacing of all the other cooling chambers (6) from one another, in which connection the numeral n denotes the serial number of the cooling chambers (6, 7), which begins with 0, and $n_{max}$ is the total number of power semiconductors (4) between the cooling-water inflow (18) and a control electrode (16), wherein the spacing of the branching (12) of the nth cooling chamber (6) from cooling-water inflow results by virtue of the relationship $n(L_0/n_{max}+LI)$.

## Revendications

1. Agencement de circuit série de semi-conducteurs (4) de puissance, comprenant un système (2) de répartition d'eau de refroidissement, comprenant des boîtes (6) à eau de refroidissement, qui sont disposées sur les semi-conducteurs (4) de puissance et qui sont en liaison conductrice de l'électricité avec les semi-conducteurs (4) de puissance, ainsi qu'au moins deux conduits (8, 9) de répartition d'eau de refroidissement, un premier conduit (8) de répartition d'eau de refroidissement ayant une arrivée (18) d'eau de refroidissement et un deuxième conduit de répartition d'eau de refroidissement ayant une évacuation (20) d'eau de refroidissement, et dans lequel les boîtes (6) de refroidissement sont montées entre les conduits (8, 9) de répartition d'eau de refroidissement en parallèle en ce qui concerne un courant (10) d'eau de refroidissement et il est prévu, pour les boîtes (6) de refroidissement, respectivement, une dérivation (12) sur les conduits (8, 9) de répartition d'eau de refroidissement et les boîtes (6) de refroidissement communiquent avec les dérivations (12) par, respectivement, un conduit (14) de liaison, dans lequel, en outre, il est monté, sur les conduits (8, 9) de répartition d'eau de refroidissement, du côté de l'extrémité, respectivement, une électrode (16) de commande, **caractérisé en ce que**, pour au moins une partie des boîtes (6) de refroidissement, les dérivations sur les conduits (8, 9) de répartition d'eau de refroidissement sont disposées de manière décalée par rapport à la position de la boîte (6) de refroidissement respective, afin d'obtenir un rattachement (22) le plus court possible géométriquement aux conduits (8, 9) de répartition d'eau de refroidissement, de manière à minimiser une différence (AU) de potentiel entre les boîtes de refroidisse-

**EP 3 394 886 B1**

ment et les dérivations.

2. Agencement de circuit série suivant la revendication 1, **caractérisé en ce que** l'arrivée (18) d'eau de refroidissement et l'évacuation (20) d'eau de refroidissement sont disposées, par rapport aux électrodes (16) de commande, au milieu sur les conduits (8, 9) de répartition d'eau de refroidissement et des dérivations (12) des boîtes (6) de refroidissement sur les conduits (8, 9) de répartition d'eau de refroidissement sont disposées de manière décalée, par rapport au boîtes (6) de refroidissement, dans la direction de l'arrivée (18) d'eau de refroidissement ou de l'évacuation (20) d'eau de refroidissement.

3. Agencement de circuit série suivant la revendication 1 ou 2, **caractérisé en ce qu'**une première dérivation (13) pour une première boîte (7) de refroidissement est mise dans la partie de l'arrivée (18) d'eau de refroidissement.

4. Agencement de circuit série suivant l'une des revendications 1 à 3, **caractérisé en ce que** les conduits (8, 9) de répartition d'eau de refroidissement sont sans autre électrode de commande.

5. Agencement de circuit série suivant l'une des revendications précédentes, **caractérisé en ce qu'**une distance $L_0$ désigne la distance entre l'arrivée (18) d'eau de refroidissement et la première boîte (7) de refroidissement et une distance $L_1$ désigne la distance constante de toutes les autres boîtes (6) de refroidissement entre elles, le chiffre n désignant le nombre continu des boîtes (6, 7) de refroidissement, qui commence par 0, et $n_{max}$ étant le nombre total des semi-conducteurs (4) de puissance entre l'arrivée (18) d'eau de refroidissement et une électrode (16) de commande, la distance entre la dérivation (12) de la nième boîte (6) de refroidissement et l'arrivée d'eau de refroidissement étant donnée par la relation $n(L_0/n_{max}+L_1)$.

FIG 1
(Stand der Technik)

FIG 2

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014204241
- US 4051509 A
- CN 1617660
- JP S57193974 B